# EUROPEAN PATENT APPLICATION

(11) **EP 4 765 211 A1**
(43) Date of publication of application: **24.06.2026**
(21) Application number: 24894276.5
(22) Date of filing: 20.06.2024
(51) Int. Cl.: H01M 4/04, H01M 10/44, G06F 30/20, G06T 17/00

(54) **METHOD AND DEVICE FOR FORMING THREE-DIMENSIONAL ELECTRODE STRUCTURE, AND METHOD AND DEVICE FOR CALCULATING MORPHOLOGICAL PARAMETER OF THREE-DIMENSIONAL ELECTRODE STRUCTURE FORMED THEREBY**

(30) Priority: 22.11.2023 KR 20230163658
(71) Applicant: LG Energy Solution, Ltd., Seoul 07335 (KR)
(72) Inventor: PARK, Joonam, Daejeon 34122 (KR); PARK, Sun Ho, Daejeon 34122 (KR); KIM, Hyeongseok, Daejeon 34122 (KR); LEE, Bora, Daejeon 34122 (KR); JUNG, Eunjoo, Daejeon 34122 (KR)
(74) Representative: Goddar, Heinz J.
(86) International application number: PCT/KR2024/008534
(87) International publication number: WO 2025/110379

(57) **Abstract**

The present invention relates to a method and device for generating a three-dimensional electrode structure, and a method and device for calculating a morphological parameter of the three-dimensional electrode structure generated thereby. A method for generating a three-dimensional electrode structure according to an exemplary embodiment of the present invention may include a coating process step of, by a coating process simulator, determining sizes of a domain and a voxel based on a design parameter input for the three-dimensional electrode structure and generating an active material, a conductive additive and binder (CBD), and a current collector in the domain using the design parameter; and a calendaring process step of, by a calendaring process simulator, simulating a rolling process for the domain using a mechanical parameter input for the three-dimensional electrode structure and correcting a structural deformation error of the rolled domain.

## Description

### [Technical Field]

### CROSS-REFERENCE TO RELATED APPLICATION

This application claims priority to and the benefit of Korean Patent Application No. 10-2023-0163658 filed in the Korean Intellectual Property Office on November 22, 2023, the entire contents of which are incorporated herein by reference.

The present invention relates to a method and device for generating a three-dimensional electrode structure, and a method and device for calculating a morphological parameter of a three-dimensional electrode structure generated thereby.

### [Background Art]

A digital twin technology is a technology that creates a twin of a real-world object in a virtual space on a computer and predicts a result by simulating a situation that may occur in a real world. The digital twin technology can be utilized in the research and development of secondary batteries.

That is, by modeling a three-dimensional electrode structure of a secondary battery in a virtual space of a computer using the digital twin technology and verifying characteristics of the generated three-dimensional electrode structure, the cost and time used in actual secondary battery processes can be reduced. In this regard, Korean Patent Application Publication No. 10-2021-0063821 discloses "a method for modeling a three-dimensional electrode structure using digital twin technology".

Note that the shape of the electrode structure can be changed depending on the design and production process conditions of a battery cell and an electrode, but the above method has a problem in that the method cannot generate a structure reflecting deformation of a cell electrode due to the design and production process of the battery cell and electrode, lacking practicality.

### [Disclosure]

### [Technical Problem]

The present invention attempts to provide a device and method capable of generating a three-dimensional electrode structure considering the design and production process conditions of a battery cell and a cell electrode, and calculating a morphological parameter of the generated three-dimensional electrode structure.

### [Technical Solution]

A method for generating a three-dimensional electrode structure according to an exemplary embodiment of the present invention may include a coating process of, by a coating process simulator, determining sizes of a domain and a voxel based on a design parameter input for the three-dimensional electrode structure and generating an active material, a conductive additive and binder (CBD), and a current collector in the domain using the design parameter; and a calendaring process of, by a calendaring process simulator, simulating a rolling process for the domain using a mechanical parameter input for the three-dimensional electrode structure and correcting a structural deformation error of the rolled domain.

The coating process may further include repeatedly generating the active material until a generation error of the active material generated in the domain falls within a preset error range.

The repeatedly generating the active material may further include determining whether a volume factor of the active material is within a preset error range and changing a condition related to generation of the active material when it is determined that the volume factor of the active material is outside the preset error range.

The coating process may further include generating the CBD in a pore generated in the domain, growing the CBD in a stepwise manner so that the CBD generated in the pore does not invade an active material region adjacent to the pore, and when a generation error of the grown CBD does not fall within a preset error range, removing a volume of the grown CBD and changing a growth direction of the CBD to re-grow the CBD.

The generating the CBD may further include determining whether the CBD is generated in the pore generated in the domain, and when it is determined that the CBD is generated outside the pore, removing the CBD generated outside the pore and changing a condition related to generation of the CBD to re-generate the CBD.

The growing the CBD in a stepwise manner may further include determining whether the grown CBD is generated in the pore generated in the domain, and when it is determined that a volume of the grown CBD is generated outside the pore, removing the volume of the CBD grown outside the pore and changing a growth direction of the CBD to re-grow the CBD.

The calendaring process may further include determining whether a deformation error calculated using a difference in volume of the active material or CBD before and after rolling falls within a preset error range, and changing an allocation group of a voxel located on a surface of the active material or CBD until the deformation error falls within a preset error range.

The calendaring process may further include determining whether a springback simulation is necessary based on a characteristic of the three-dimensional electrode structure, and performing the springback simulation using a stress value calculated in the rolling process simulation when it is determined that the springback simulation is necessary.

The calendaring process may further include determining whether a lamination process simulation is necessary based on a characteristic of the three-dimensional electrode structure, and performing the lamination process simulation by receiving an additional input of a machine parameter necessary for the lamination process and calculating a roll pressure when it is determined that the lamination process simulation is necessary.

The method may further include an activation process when the three-dimensional electrode structure generated through the coating process and the calendaring process is a negative electrode structure, and the activation process may include, by an activation process simulator, generating a half-cell structure of the three-dimensional electrode structure by using an electrochemical parameter input for the three-dimensional electrode structure, simulating a battery charging process for the half-cell structure to calculate a lithium ion concentration value in the active material according to a state of lithiation (SOL) of the three-dimensional electrode structure, and simulating active material expansion by using an amount of change in the lithium ion concentration value in the active material to generate the three-dimensional electrode structure for each SOL.

According to an exemplary embodiment of the present invention, there is provided a method for calculating a morphological parameter of a three-dimensional electrode structure generated by the method for generating a three-dimensional electrode structure described above may further include, by a processor, calculating a morphological parameter for the three-dimensional electrode structure by using a physical property parameter input for the three-dimensional electrode structure.

According to an exemplary embodiment of the present invention, there is provided a device for generating a three-dimensional electrode structure including a processor configured to receive an input of a design parameter and a mechanical parameter and to generate a three-dimensional electrode structure based on the design parameter and mechanical parameter; a coating process simulator configured to simulate a coating process by determining sizes of a domain and a voxel based on the design parameter and generating an active material, a conductive additive and binder (CBD), and a current collector in the domain using the design parameter; and a calendaring process simulator configured to simulate a rolling process for the domain using the mechanical parameter and to simulate a calendaring process by correcting a structural deformation error of the rolled domain.

The coating process simulator may be configured to repeatedly generate the active material until a generation error of the active material generated in the domain falls within a preset error range.

The coating process simulator may be configured to determine whether a volume factor of the active material is within a preset error range, and to change a condition related to generation of the active material when it is determined that the volume factor of the active material is outside the preset error range.

The coating process simulator may be configured to generate the CBD in a pore generated in the domain, to grow the CBD in a stepwise manner so that the CBD generated in the pore does not invade an active material region adjacent to the pore, and when a generation error of the grown CBD does not fall within a preset error range, to remove a volume of the grown CBD and change a growth direction of the CBD to re-grow the CBD.

The coating process simulator may be configured to determine whether the CBD is generated in the pore generated in the domain, and when it is determined that the CBD is generated outside the pore, to remove the CBD generated outside the pore and change a condition related to generation of the CBD to re-generate the CBD.

The coating process simulator may be configured to determine whether the grown CBD is generated in the pore generated in the domain, and when it is determined that a volume of the grown CBD is generated outside the pore, to remove the volume of the CBD grown outside the pore and change a growth direction of the CBD to re-grow the CBD.

The calendaring process simulator may be configured to determine whether a deformation error calculated using a difference in volume of the active material or CBD before and after rolling falls within a preset error range, and to change an allocation group of a voxel located on a surface of the active material or CBD until the deformation error falls within a preset error range.

The calendaring process simulator may be configured to determine whether a springback simulation is necessary based on a characteristic of the three-dimensional electrode structure, and to perform the springback simulation using a stress value calculated in the rolling process simulation when it is determined that the springback simulation is necessary.

The calendaring process simulator may be configured to determine whether a lamination process simulation is necessary based on a characteristic of the three-dimensional electrode structure, and to perform the lamination process simulation by receiving an additional input of a machine parameter necessary for the lamination process and calculating a roll pressure when it is determined that the lamination process simulation is necessary.

The processor may be configured to receive an additional input of a mechanochemical parameter, the device may further include an activation process simulator, and the activation process simulator may be configured, when the three-dimensional electrode structure generated through the coating process simulator and the calendaring process simulator is a negative electrode structure, to generate a half-cell structure of the three-dimensional electrode structure by using the electrochemical parameter, to simulate a battery charging process for the half-cell structure to calculate a lithium ion concentration value in the active material according to a state of lithiation (SOL) of the three-dimensional electrode structure, and to simulate active material expansion by using an amount of change in the lithium ion concentration value in the active material to generate the three-dimensional electrode structure for each SOL.

According to an exemplary embodiment of the present invention, there is provided a device for calculating a morphological parameter of the three-dimensional electrode structure generated by the device for generating a three-dimensional electrode structure, wherein the processor is configured to receive an input of a physical property parameter for the three-dimensional electrode structure and to calculate a morphological parameter for the three-dimensional electrode structure by using the physical property parameter.

### [Advantageous Effects]

According to an exemplary embodiment of the present invention, it is possible to generate a three-dimensional electrode structure that takes into account the design and production process conditions of the battery cell and electrode, and to calculate a morphological parameter of the three-dimensional electrode structure generated as such. This allows for prediction of electrode performance according to the design and process conditions of the electrode, and suggestion of improvement directions accordingly.

The effects obtainable in the present invention are not limited to the effects described above, and other effects not described will be apparently understood by one skilled in the art from the following description.

### [Description of the Drawings]

FIG. 1 is a flowchart for illustrating a method for generating a three-dimensional electrode structure according to an exemplary embodiment of the present invention.
FIG. 2 is a flowchart for illustrating a coating process step according to an exemplary embodiment of the present invention.
FIG. 3 shows an Example of a three-dimensional electrode structure generated through the coating process step.
FIG. 4 is a flowchart for illustrating the step of generating a conductive additive and binder according to an exemplary embodiment of the present invention.
FIG. 5 is a flowchart for illustrating a calendaring process step according to an exemplary embodiment of the present invention.
FIG. 6 shows an Example of a three-dimensional electrode structure generated via a rolling process simulation in the calendaring process step.
FIG. 7 shows an Example of a three-dimensional electrode structure generated via a springback simulation and a lamination simulation.
FIG. 8 is a flowchart for illustrating an activation process step according to an exemplary embodiment of the present invention.
FIG. 9 shows an Example of a three-dimensional electrode structure generated via the activation process step.
FIG. 10 is a flowchart of a method for calculating a morphological parameter of a three-dimensional electrode structure according to an exemplary embodiment of the present invention.
FIG. 11 is a block diagram for illustrating a device for generating a three-dimensional electrode structure and a device for calculating a morphological parameter of a three-dimensional electrode structure according to an exemplary embodiment of the present invention.

### [Mode for Invention]

In describing an exemplary embodiment disclosed in the present specification, a detailed description of related known technologies will be omitted if it is determined that the detailed description makes the gist of the embodiment of the present specification unclear. Further, the accompanying drawings are provided for helping to easily understand exemplary embodiments disclosed in the present specification, and the technical spirit disclosed in the present specification is not limited by the accompanying drawings, and it will be appreciated that the present invention includes all of the modifications, equivalent matters, and substitutes included in the spirit and the technical scope of the present invention.

Terms including an ordinary number, such as first and second, are used for describing various constituent elements, but the constituent elements are not limited by the terms. The terms are used only to discriminate one constituent element from another constituent element.

When it is mentioned that a certain constituent element is "connected" or "coupled" to another constituent element, it should be understood that the certain constituent element may be directly connected or coupled to the other constituent element or another intervening constituent element may be located therebetween. Conversely, when a certain constituent element is referred to as being "directly connected" or "directly coupled" to another constituent element, it should be understood that there is no intervening constituent element present.

In the present application, it will be appreciated that terms "including" and "having" are intended to designate the existence of characteristics, numbers, steps, operations, constituent elements, and components described in the specification or a combination thereof, and do not exclude a possibility of the existence or addition of one or more other characteristics, numbers, steps, operations, constituent elements, and components, or a combination thereof in advance.

Exemplary embodiments of the present invention will be described in detail below with reference to the accompanying drawings.

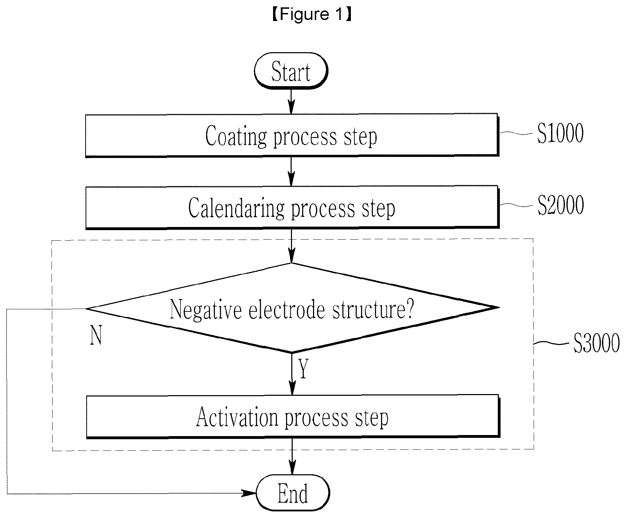

FIG. 1 is a flowchart for illustrating a method for generating a three-dimensional electrode structure according to an exemplary embodiment of the present invention.

Referring to FIG. 1, a method for generating a three-dimensional electrode structure according to an exemplary embodiment of the present invention may include a coating process step (S1000) and a calendaring process step (S2000).

In some exemplary embodiments, the method for generating a three-dimensional electrode structure may further include an activation process step (S3000) when the three-dimensional electrode structure generated through the coating process step (S1000) and the calendaring process step (S2000) is a negative electrode structure.

The coating process step (S1000) can be performed by a coating process simulator 100, the calendaring process step (S2000) can be performed by a calendaring process simulator 200, and the activation process step (S3000) can be performed by an activation process simulator 300, and in each step, each simulator can receive a parameter necessary for simulating the process from a processor 400.

That is, the method for generating a three-dimensional electrode structure according to the present invention can analyze characteristics of the electrode structure that change depending on each process condition by generating a three-dimensional electrode structure for each actual process step of the electrode structure.

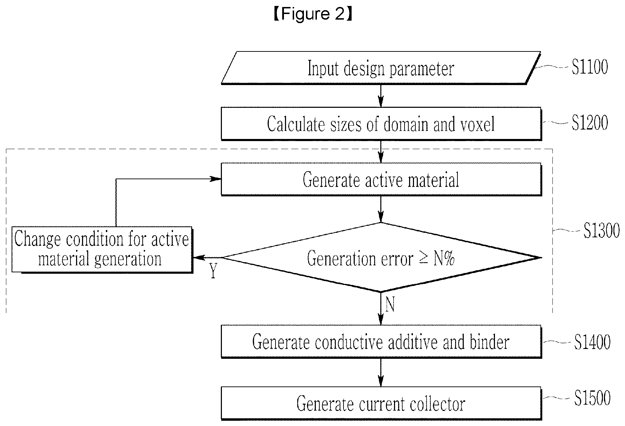

Below, each step of the method for generating a three-dimensional electrode structure will be described in more detail with reference to FIGS. 2 to 9.

FIG. 2 is a flowchart for illustrating a coating process step according to an exemplary embodiment of the present invention.

In the coating process step (S1000), the coating process simulator 100 can determine sizes of a domain and a voxel based on a design parameter input for a three-dimensional electrode structure and generate an active material, a CBD, and a current collector in the domain using the design parameter.

Referring to FIG. 2, the coating process step (S1000) according to an exemplary embodiment of the present invention may include a design parameter input step (S1100), a domain and voxel size calculation step (S1200), an active material generation step (S1300), a conductive additive and binder generation step (S1400), and a current collector generation step (S1500).

In the design parameter input step (S1100), the coating process simulator 100 can receive a design parameter input for a three-dimensional electrode structure from the processor 400.

Here, the design parameter refers to a variable required to generate a three-dimensional electrode structure, and may include a loading level of an electrode, a content and net density of each component included in the three-dimensional electrode structure, a size distribution and a sphericity of an active material, a quantified binder ratio (QBR) of a conductive additive and binder (CBD), a thickness of a current collector, or the like, in some exemplary embodiments.

In some exemplary embodiments, the number of design parameter used may increase when applying multiple types of active materials, when designing a double-layer electrode, when changing a design of an inactive material, or the like. For example, when applying one type of active material, one design parameter may be used, and when applying two types of active materials, two design parameters may be used. In this case, each design parameter may include a loading level of an electrode, a content and a net density of each component included in the three-dimensional electrode structure, a size distribution and a sphericity of an active material, a quantified binder ratio (QBR) of a conductive additive and binder (CBD), or a thickness of a current collector.

In the domain and voxel size calculation step (S1200), sizes of a domain and a voxel may be set based on the design parameter input for a three-dimensional electrode structure.

In some exemplary embodiments, the sizes of the domain and voxel set through the coating process step (S1000) may be set based on a diameter of an active material particle. For example, the size of the domain may be set to 3 times a diameter of the largest active material particle, and the size of the voxel may be set to 1/30 of a diameter of the smallest active material particle.

In the active material generation step (S1300), the conductive additive and binder generation step (S1400), and the current collector generation step (S1500), the active material, the CBD, and the current collector can be generated in the domain using the design parameter.

In some exemplary embodiments, the active material generated in the domain may be generated using random sequential absorption (RSA) or discrete element method (DEM), the CBD may be generated using RSA and a particle growth algorithm based on the content and QBR value of the CBD, and the current collector may be generated at a bottom of an electrode generated in the domain.

The active material generation step (S1300) may further include a step of repeatedly generating the active material until a generation error of the active material generated in the domain falls within a preset error range.

The step of repeatedly generating the active material may further include a step of determining whether a volume factor of the active material is within a preset error range and a step of changing a condition related to generation of the active material when it is determined that the volume factor of the active material is outside the preset error range. Here, the condition related to the generation of the active material may be changed by changing a numerical value of a random seed.

In some exemplary embodiments, in the determination as to whether the volume factor of the active material is within a preset error range, the volume factor of the active material may be determined to be outside the preset error range when a value of the volume factor is an arbitrary number or larger. In this case, the arbitrary number may be set by the user and input through the processor 400.

In some exemplary embodiments, the volume factor of the active material may be a value calculated by dividing a difference between a loading level of the active material input as a design parameter and a loading level of the active material generated in the domain by the input loading level of the active material.

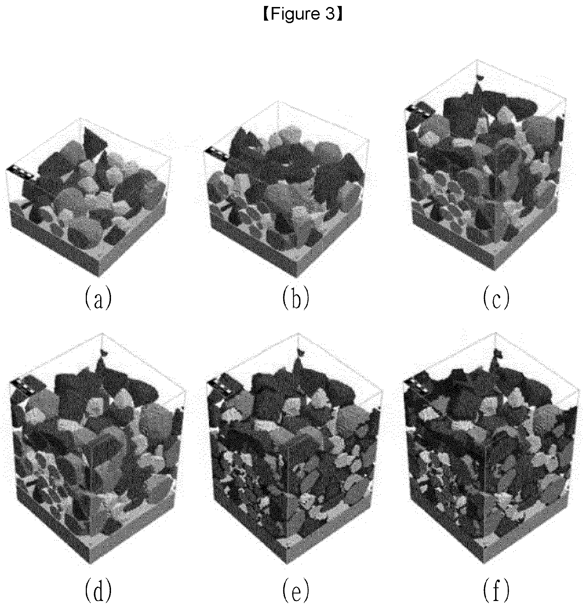

FIG. 3 shows an Example of a three-dimensional electrode structure generated through the coating process step.

As shown in FIG. 3, red flake-shaped particles, green sphere-shaped particles, and yellow polyhedron-shaped particles are generated in the domain of the electrode structure generated through the coating process step (S1000) according to an exemplary embodiment of the present invention. That is, the three-dimensional electrode structure generated by the coating process step (S1000) according to an exemplary embodiment of the present invention allows for generation of active material particles reflecting different sphericities.

(a) to (c) in FIG. 3 show Examples of a three-dimensional electrode structure generated when the loading levels of the electrode are 50 mg/25 cm2, 100 mg/25 cm2, and 200 mg/25cm2, respectively. With this, it can be confirmed that it is possible to simulate an electrode with controlled loading level of the electrode in the coating process step (S1000) according to an exemplary embodiment of the present invention.

(d) to (f) in FIG. 3 show a distribution of CBD generated in the three-dimensional electrode structure according to the QBR value. (d) in FIG. 3 shows a state in which the CBD is not generated in the three-dimensional electrode structure, (e) in FIG. 3 shows a state (Homogeneous) in which the QBR value is close to 1 and there is no difference in the amount of CBD in the electrode thickness direction, and (f) in FIG. 3(f) shows a state (Gradient) in which the QBR value is greater than 1 and the amount of CBD increases in the electrode thickness direction. That is, the coating process step (S1000) according to an exemplary embodiment of the present invention can control the distribution of CBD generated in the three-dimensional electrode structure by adjusting the QBR value. With this, a phenomenon of the CBD moving to an upper layer of the electrode (migration phenomenon), which may occur during a solvent drying process when manufacturing an electrode, can be reflected in the three-dimensional electrode structure.

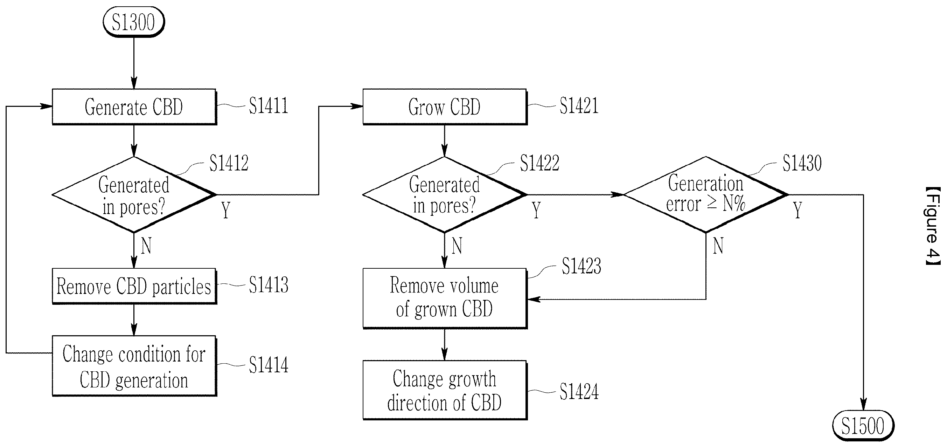

FIG. 4 is a flowchart for illustrating the step of generating a conductive additive and binder according to an exemplary embodiment of the present invention.

Referring to FIG. 4, the step of generating a conductive additive and binder (S1400) according to an exemplary embodiment of the present invention may include a step of generating a CBD (S1410), a step of growing the CBD in a stepwise manner (S1420), and a step of re-growing the CBD (S1430).

The step of generating a CBD (S1410) may generate a CBD in pores generated in the domain. In some exemplary embodiments, the step of generating a CBD (S1410) may further include a step of generating a CBD in pores generated in the domain (S1411), a step of determining whether the CBD is generated in the pores generated in the domain (S1412), and a step of, when it is determined that the CBD is generated outside the pores, removing the CBD generated outside the pores (S1413) and changing a condition related to generation of the CBD to re-generate the CBD (S1414). That is, the step of generating a CBD (S1410) may be performed repeatedly until the CBD generated in the domain is included in the pores. Here, the condition related to generation of the CBD may be changed by changing the numerical value of the random seed related to the generation of CBD.

The step of growing CBD in a stepwise manner (S1420) may grow the CBD in a stepwise manner so that the CBD generated in the pores does not invade an active material region adjacent to the pores. Here, the active material region may refer to a region generated in a domain by voxels assigned with an attribute of an active material, and growing the CBD in a stepwise manner so as not to invade the active material region may mean growing the CBD up to voxels located around the voxels assigned with the attribute of an active material.

In some exemplary embodiments, the step of growing the CBD in a stepwise manner (S1420) may further include a step of growing the CBD in a stepwise manner so that the CBD generated in the pores does not invade an active material region adjacent to the pores (S1421), a step of determining whether the grown CBD is generated in the pores generated in the domain (S1422), and when it is determined that a volume of the grown CBD is generated outside the pores, a step of removing the volume of the CBD grown outside the pores (S1423) and changing a growth direction of the CBD to re-grow the CBD (S1424). That is, the step of growing the CBD in a stepwise manner (S1420) may be performed repeatedly until the entire volume of the grown CBD is included in the pores.

The step of re-growing the CBD (S1430) may include, when a generation error of the grown CBD does not fall within a preset error range, removing a volume of the grown CBD and changing a growth direction of the CBD to re-grow the CBD. That is, the step of re-growing the CBD (S1430) may be performed repeatedly until the generation error of the CBD falls within a preset error range.

Here, the generation error of the CBD may be calculated based on the loading level of the CBD. For example, the generation error of the CBD may be a value obtained by dividing a difference between the loading level of the CBD input as a design parameter and the loading level of the CBD generated in the domain by the input loading level of the CBD.

In some exemplary embodiments, in determining whether the generation error falls within a preset error range, the generation error may be determined to be outside the preset error range when the value of the generation error is an arbitrary number or larger. In this case, the arbitrary number may be set by the user and input through the processor 400.

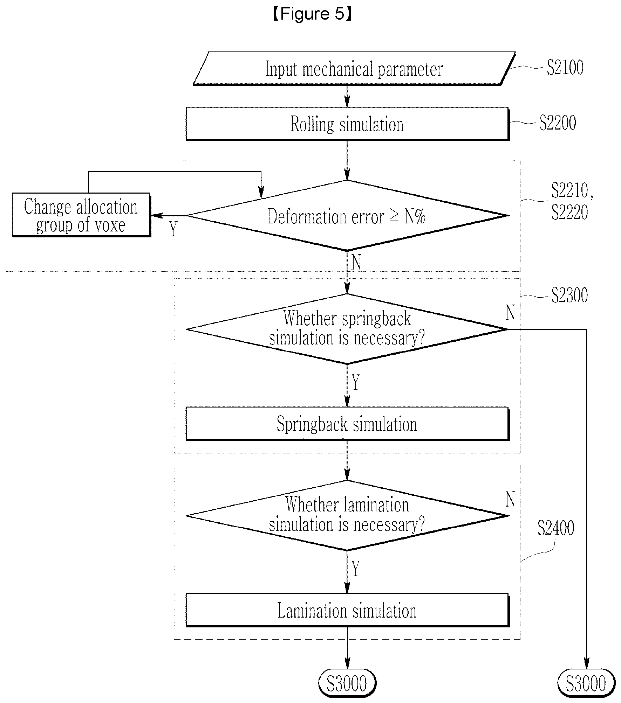

FIG. 5 is a flowchart for illustrating a calendaring process step according to an exemplary embodiment of the present invention.

In the calendaring process step (S2000), the calendaring process simulator 200 may simulate a rolling process for the domain using the machine parameter input for the three-dimensional electrode structure and correct a structural deformation error of the rolled domain.

Referring to FIG. 5, the calendaring process step (S2000) according to an exemplary embodiment of the present invention may include a machine parameter input step (S2100) and a rolling simulation step (S2200), and may further include a springback simulation step (S2300) or a lamination simulation step (S2400).

In the machine parameter input step (S2100), the calendaring process simulator 200 may receive a machine parameter input for the three-dimensional electrode structure from the processor 400.

Here, the machine parameter refers to a variable required to simulate a calendaring process, and may include a rolling thickness of an electrode, a Young's modulus, a Poisson's ratio, a yield stress, or a hardening modulus, in some exemplary embodiments.

In the rolling simulation step (S2200), the rolling process may be simulated by the calendaring process simulator 200 for the three-dimensional electrode structure for which the coating process simulation has been completed. At this time, the three-dimensional electrode structure for which the coating process simulation has been completed may be transferred from the coating process simulator 100 to the calendaring process simulator 200 via the processor 400.

In some exemplary embodiments, the calendaring process simulator 200 can simulate the rolling process by coupling a strain-displacement equation and an equilibrium equation to simulate displacement and stress of components included in the three-dimensional electrode structure according to the strain.

The rolling simulation step (S2200) may further include a step (S2210) of determining whether a deformation error calculated using a difference in volume of the active material or CBD before and after rolling falls within a preset error range, and a step (S2220) of changing an allocation group of a voxel located on a surface of the active material or CBD until the deformation error falls within the preset error range. That is, the rolling simulation step (S2200) may be performed repeatedly until the deformation error falls within the preset error range.

Here, the deformation error may be determined based on a volume of components included in the three-dimensional electrode structure. For example, the deformation error of the active material may be a value obtained by dividing a difference in volume of the active material in the three-dimensional electrode structure before and after rolling by a volume of the active material before rolling, and the deformation error of the CBD may be a value obtained by dividing a difference in volume of the CBD in the three-dimensional electrode structure before and after rolling by a volume of the CBD before rolling.

In some exemplary embodiments, in determining whether the deformation error falls within a preset error range, the deformation error may be determined to be outside the preset error range when the value of the deformation error is an arbitrary number or larger. In this case, the arbitrary number may be set by the user and input through the processor 400.

In some exemplary embodiments, the step (S2220) of changing the allocation group of a voxel located on the surface of the active material or CBD until the deformation error falls within a preset error range may include changing the allocation group of a voxel located on the surface of the active material when the deformation error of the active material is outside the preset error range, and changing the allocation group of a voxel located on the surface of the CBD when the deformation error of the CBD is outside the preset error range. For example, when the volume of the active material is excessively reduced after rolling and the deformation error is outside the preset error range, the deformation error can be reduced by changing an attribute assigned to the voxels located on the surface of the active material to an active material to increase the volume of the active material after rolling. The same is true for the CBD.

In some exemplary embodiments, when there are multiple voxels located on the surface of the active material or CBD, the allocation groups of the multiple voxels can be changed one by one until the deformation error falls within the preset error range. That is, the present invention can correct the deformation error of a three-dimensional electrode structure, which is caused by the rolling simulation, by increasing or decreasing the number of voxels corresponding to the active material or CBD.

The springback simulation step (S2300) may further include a step of determining whether a springback simulation is necessary based on a characteristic of the three-dimensional electrode structure, and a step of performing the springback simulation using a stress value calculated in the rolling process simulation when it is determined that the springback simulation is necessary.

In some exemplary embodiments, the determination as to whether a springback simulation is necessary may be made based on whether the processor 400 receives, from the outside, a signal including a command to perform a springback simulation. In this case, the signal to give a command to perform a springback simulation may be input along with a parameter input through the processor 400.

In addition, the determination as to whether a springback simulation is necessary may be made based on a characteristic or type of a three-dimensional electrode structure to be generated through the present invention. For example, it may be determined that a springback simulation is necessary when a degree of rolling is equal to or greater than a preset reference value or in the case of a negative electrode structure. In this case, the characteristic of the three-dimensional electrode structure may be included in the parameter for the three-dimensional electrode structure input through the processor 400, or may be input along with the parameter for the three-dimensional electrode structure.

The lamination simulation step (S2400) may further include a step of determining whether a lamination process simulation is necessary based on a characteristic of the three-dimensional electrode structure, and a step of performing the lamination process simulation by receiving an additional input of a machine parameter necessary for the lamination process and calculating a roll pressure when it is determined that the lamination process simulation is necessary.

In some exemplary embodiments, the determination as to whether the lamination simulation is necessary may be made based on whether the processor 400 receives, from the outside, a signal including a command to perform a lamination simulation or a characteristic or type of a three-dimensional electrode structure to be generated through the present invention. In this case, the signal to give a command to perform a lamination simulation or the characteristic of the three-dimensional electrode structure may be input along with a parameter for the three-dimensional electrode structure.

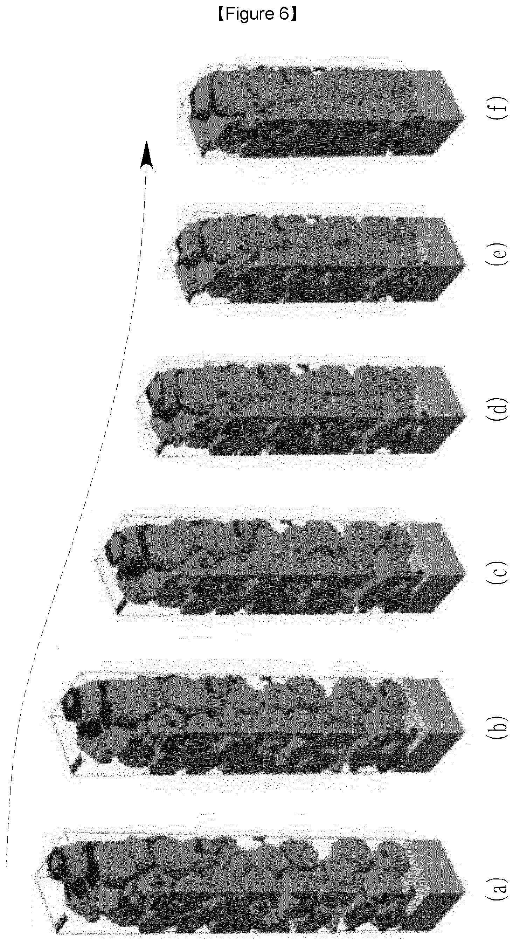

FIG. 6 shows an Example of a three-dimensional electrode structure generated via a rolling process simulation in the calendaring process step.

As shown in FIG. 6, the calendaring process step (S2000) according to an exemplary embodiment of the present invention may generate a three-dimensional electrode structure for each of degrees of rolling. (a) to (f) in FIG. 6 shows an Example of a three-dimensional electrode structure for a process of rolling an arbitrary positive electrode structure to 66% of its original thickness.

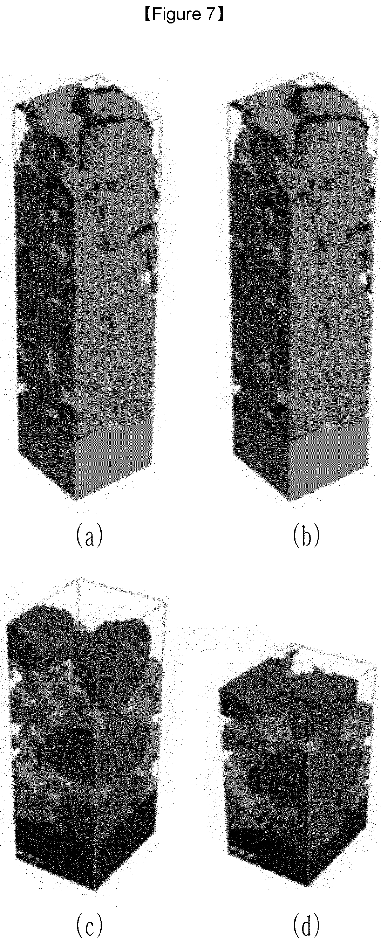

FIG. 7 shows an Example of a three-dimensional electrode structure generated via a springback simulation and a lamination simulation.

As shown in FIG. 7, according to the calendaring process step (S2000) according to an exemplary embodiment of the present invention, it is possible to generate a three-dimensional electrode structure before and after the springback phenomenon occurs or before and after the lamination process is performed, respectively.

(a) in FIG. 7 shows an example of a three-dimensional electrode structure before springback simulation, (b) in FIG. 7 shows an example of a three-dimensional electrode structure after springback simulation, (c) in FIG. 7 shows an example of a three-dimensional electrode structure before lamination simulation, and (d) in FIG. 7 shows an example of a three-dimensional electrode structure after lamination simulation.

That is, by using a three-dimensional electrode structure generated through the calendaring process step (S2000) according to an exemplary embodiment of the present invention, it is possible to confirm changes in characteristics of the three-dimensional electrode structure before and after the occurrence of the springback phenomenon and before and after the lamination process, as shown in Tables 1 and 2 below.

**(Table 1)**

| | Before springback simulation | After springback simulation |
|---|---|---|
| Electrode thickness (w/Cu, µm) | 66.00 | 66.66 |
| Porosity (%) | 13.20 | 13.20 |
| NCM volume fraction (%) | 67.97 | 68.12 |
| PVdF volume fraction (%) | 3.35 | 3.35 |
| Al volume fraction (%) | 15.48 | 15.33 |
| Equivalent stress (VonMises Strain) (%) | - | 0.95 |

**(Table 2)**

| | Before lamination simulation | After lamination simulation |
|---|---|---|
| Electrode thickness (w/Cu, µm) | 35.11 | 24.79 |
| Porosity (%) | 31.95 | 26.38 |
| Large NCM/NCMA volume fraction (%) | 28.25 | 30.47 |
| Small NCM/NCMA volume fraction (%) | 18.74 | 21.31 |
| CBD volume fraction (%) | 0.54 | 0.21 |

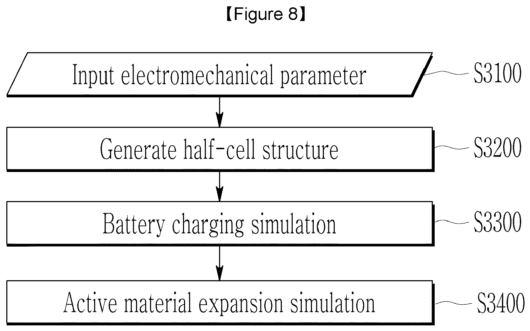

FIG. 8 is a flowchart for illustrating an activation process step according to an exemplary embodiment of the present invention.

Referring to FIG. 8, the activation process step (S3000) may include an electrochemical parameter input step (S3100), a half-cell structure generation step (S3200), a battery charging simulation step (S3300), and an active material expansion simulation step (S3400).

In the electrochemical parameter input step (S3100), the activation process simulator 300 may receive an electrochemical parameter input for a three-dimensional electrode structure from the processor 400. At this time, the activation process simulator 300 may receive a three-dimensional electrode structure for which the coating process and calendaring process simulations have been completed from the calendaring process simulator 200 through the processor 400.

Here, the electrochemical parameter refers to a variable required to simulate the activation process, and may include an electrical conductivity of the active material, an electrical conductivity of the CBD, a membrane design condition, a cation transfer coefficient of an electrolyte, an ionic conductivity, a diffusion coefficient, or a rate-limiting condition, in some exemplary embodiments.

In the half-cell structure generation step (S3200), a half-cell structure of the three-dimensional electrode structure may be generated using the electrochemical parameter input for the three-dimensional electrode structure.

Here, the half-cell structure is generated in order to determine electrochemical characteristics of the three-dimensional electrode structure, and may have such a form that a reference electrode is added to the three-dimensional electrode structure generated through the coating process step (S1000) and the calendaring process step (S2000). In some exemplary embodiments, the reference electrode may be implemented with lithium metal capable of infinitely supplying lithium ions to the three-dimensional electrode structure.

In the battery charging simulation step (S3300), a battery charging process may be simulated for the half-cell structure according to a rate-limiting condition input as the electrochemical parameter, and a lithium ion concentration value in the active material according to a state of lithiation (SOL) of the three-dimensional electrode structure may be calculated. Here, the SOL indicates a state of charge of the three-dimensional electrode structure.

In the active material expansion simulation step (S3400), expansion of the active material may be simulated using an amount of change in the lithium ion concentration value in the active material, and a three-dimensional electrode structure may be generated for each SOL.

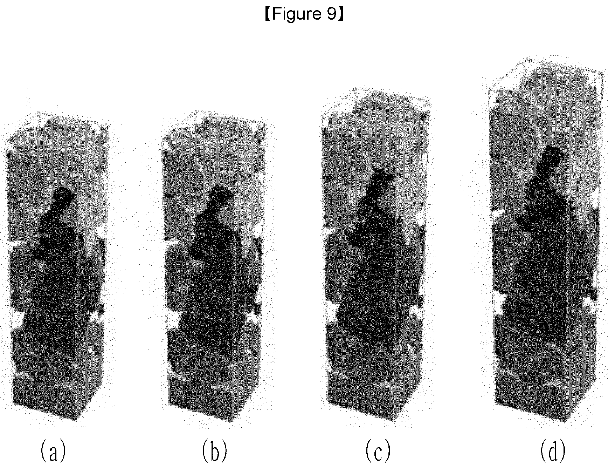

FIG. 9 shows an Example of a three-dimensional electrode structure generated via the activation process step.

As shown in (a) to (d) in FIG. 9, according to the activation process step (S3000) according to an exemplary embodiment of the present invention, a three-dimensional electrode structure for each charging state may be generated.

That is, by using the three-dimensional electrode structure generated through the activation process step (S3000) according to an exemplary embodiment of the present invention, the characteristics of the three-dimensional electrode structure according to the state of charge can be confirmed as shown in Table 3 below.

**(Table 3)**

| | SOL 0 | SOL 10 | SOL 50 | SOL 90 |
|---|---|---|---|---|
| Electrode thickness (w/Cu, µm) | 82.50 | 82.90 | 85.66 | 88.03 |
| Porosity (%) | 34.06 | 33.96 | 31.10 | 29.04 |
| Artificial graphite volume fraction (%) in lower layer portion | 17.23 | 17.34 | 18.64 | 19.97 |
| Natural graphite volume fraction (%) in lower layer portion | 13.00 | 13.15 | 13.79 | 14.84 |
| Artificial graphite volume fraction (%) in upper layer portion | 19.66 | 19.60 | 21.30 | 21.73 |
| Si/SiOx volume fraction (%) in upper layer portion | 1.31 | 1.30 | 1.26 | 1.24 |

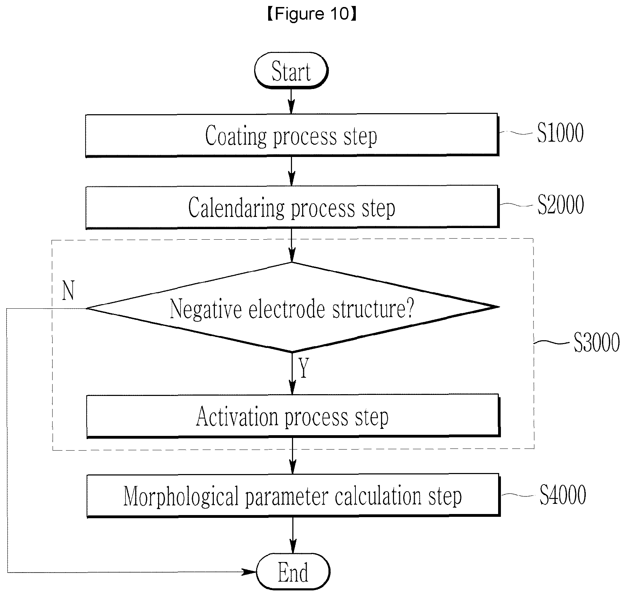

FIG. 10 is a flowchart of a method for calculating a morphological parameter of a three-dimensional electrode structure according to an exemplary embodiment of the present invention.

Referring to FIG. 10, a method for calculating a morphological parameter of a three-dimensional electrode structure according to an exemplary embodiment of the present invention may further include a morphological parameter calculation step (S4000) in the method for generating a three-dimensional electrode structure described above.

In the morphological parameter calculation step (S4000), the processor 400 may receive an additional input of a physical property parameter for the three-dimensional electrode structure, and may calculate a morphological parameter for the three-dimensional electrode structure generated by the method for generating a three-dimensional electrode structure described above by using the input physical property parameter.

Here, the physical property is a variable required to calculate a morphological parameter, and may be input from the outside through a user terminal or the like, or may be acquired by the processor 400 from a three-dimensional electrode structure generated by the method described above.

Additionally, the morphological parameter may include i) a specific surface area, a volume fraction and a porosity among components included in a three-dimensional electrode structure, ii) a radius of an active material particle, iii) an effective electrical conductivity of an electrode layer, and iv) an ionic tortuosity.

In this case, known techniques in the related art may be used for the method for calculating a morphological parameter from a physical property parameter. For example, the radius of an active material particle may be calculated based on the Watershed algorithm, the specific surface area, volume fraction, and porosity may be calculated based on the Voxel Statistical Analysis, and the effective electrical conductivity and ionic tortuosity may be calculated based on the Ohm's Law partial differential equation calculation.

Note that the above-described method can be prepared as a program that can be executed on a computer, and can be implemented on a general-purpose digital computer that operates the program using a computer-readable recording medium. The computer-readable recording medium may include a storage medium such as a magnetic storage medium such as a ROM, a RAM, a USB, a floppy disk, or a hard disk, or an optical readable medium such as a CD-ROM or a DVD.

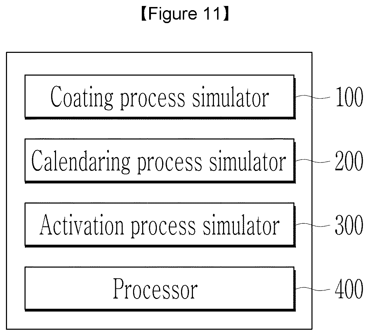

FIG. 11 is a block diagram for illustrating a device for generating a three-dimensional electrode structure and a device for calculating a morphological parameter of a three-dimensional electrode structure according to an exemplary embodiment of the present invention.

Referring to FIG. 11, a device for generating a three-dimensional electrode structure according to an exemplary embodiment of the present invention may include the coating process simulator 100, the calendaring process simulator 200, and the processor 400.

In some exemplary embodiments, the device for generating a three-dimensional electrode structure may further include an activation process simulator 300 in addition to the coating process simulator 100, the calendaring process simulator 200, and the processor 400 when the three-dimensional electrode structure to be generated is a negative electrode structure. In this case, the processor 400 may receive an input of mechanochemical parameters in addition to the design and mechanical parameters.

The coating process simulator 100 may simulate a coating process by determining sizes of a domain and a voxel based on the design parameter received through the processor 400 and generating an active material, a conductive additive and binder (CBD), and a current collector in the domain using the design parameter.

Here, the active material generated in the domain by the coating process simulator 100 may be repeatedly generated until a generation error of the active material falls within a preset error range. At this time, the coating process simulator 100 may determine whether a volume factor of the active material falls within a preset error range, and may repeatedly generate the active material by changing a condition related to generation of the active material when it is determined that the volume factor of the active material is outside the preset error range.

The CBD generated by the coating process simulator 100 may be generated in pores generated in the domain and may be grown in a stepwise manner so as not to invade an active material region adjacent to the pores.

At this time, the coating process simulator 100 may determine whether the CBD is generated in the pores generated in the domain, and when it is determined that the CBD is generated outside the pores, remove the CBD generated outside the pores and change the condition related to generation of the CBD to re-generate the CBD.

In addition, the coating process simulator 100 may determine whether the grown CBD is generated in the pores generated in the domain, and when it is determined that a volume of the grown CBD is generated outside the pores, remove the volume of the CBD grown outside the pores and change a growth direction of the CBD to re-grow the CBD.

In addition, the coating process simulator 100 may remove the volume of the grown CBD and change the growth direction of the CBD to re-grow the CBD when a generation error of the grown CBD does not fall within a preset error range.

The calendaring process simulator 200 may simulate a rolling process for the domain using a machine parameter received through the processor 400 and simulate the calendaring process by correcting a structural deformation error of the rolled domain.

In this case, the calendaring process simulator 200 may determine whether a deformation error calculated using a difference in volume of the active material or CBD before and after rolling falls within a preset error range, and correct the structural deformation error of the domain by changing an allocation group of a voxel located on a surface of the active material or CBD until the deformation error falls within the preset error range.

In some exemplary embodiments, the calendaring process simulator 200 may determine whether a springback simulation is necessary based on a characteristic of the three-dimensional electrode structure, and perform the springback simulation using a stress value calculated in the rolling process simulation when it is determined that the springback simulation is necessary.

In some exemplary embodiments, the calendaring process simulator 200 may determine whether a lamination process simulation is necessary based on a characteristic of the three-dimensional electrode structure, and perform the lamination process simulation by receiving an additional input of a machine parameter necessary for the lamination process and calculating a roll pressure when it is determined that the lamination process simulation is necessary.

The activation process simulator 300 may generate a half-cell structure of the three-dimensional electrode structure by using the electrochemical parameter received through the processor 400, simulate a battery charging process for the half-cell structure to calculate a lithium ion concentration value in the active material according to a state of lithiation (SOL) of the three-dimensional electrode structure, and simulate active material expansion by using an amount of change in the lithium ion concentration value in the active material to generate the three-dimensional electrode structure for each SOL.

The processor 400 may receive an input of a design parameter and a mechanical parameter from the outside, transmit the design parameters and mechanical parameter to the coating process simulator 100 and the calendaring process simulator 200, respectively, and simulate the coating process and the calendaring process to generate a three-dimensional electrode structure. Here, the outside may be a user terminal, a higher controller, or the like.

A device for calculating a morphological parameter of a three-dimensional electrode structure according to an exemplary embodiment of the present invention is a device for calculating a morphological parameter of a three-dimensional electrode structure generated by the device for generating a three-dimensional electrode structure described above, and may include the same configuration as the device for generating a three-dimensional electrode structure described above, and the processor 400 of the device for calculating a morphological parameter of a three-dimensional electrode structure may receive an input of a physical property parameter for a three-dimensional electrode structure and calculate a morphological parameter for the three-dimensional electrode structure using the physical property parameter.

Although the exemplary embodiments of the present invention have been described in detail, the scope of the present invention is not limited thereto, and various modifications and improvements made by one skilled in the art by using the basic concept of the present invention defined in the following claims also fall within in the scope of the present invention.

## Claims

1. A method for generating a three-dimensional electrode structure using a device for generating a three-dimensional electrode structure, the method comprising:
a coating process of, by a coating process simulator, determining sizes of a domain and a voxel based on a design parameter input for the three-dimensional electrode structure and generating an active material, a conductive additive and binder (CBD), and a current collector in the domain using the design parameter; and
a calendaring process of, by a calendaring process simulator, simulating a rolling process for the domain using a mechanical parameter input for the three-dimensional electrode structure and correcting a structural deformation error of the rolled domain.

2. The method of claim 1, wherein:
the coating process further comprises
repeatedly generating the active material until a generation error of the active material generated in the domain falls within a preset error range.

3. The method of claim 2, wherein:
the repeatedly generating the active material further comprises:
determining whether a volume factor of the active material is within a preset error range; and
changing a condition related to generation of the active material when it is determined that the volume factor of the active material is outside the preset error range.

4. The method of claim 1, wherein:
the coating process further comprises:
generating the CBD in a pore generated in the domain;
growing the CBD in a stepwise manner so that the CBD generated in the pore does not invade an active material region adjacent to the pore; and
when a generation error of the grown CBD does not fall within a preset error range, removing a volume of the grown CBD and changing a growth direction of the CBD to re-grow the CBD.

5. The method of claim 4, wherein:
the generating the CBD further comprises:
determining whether the CBD is generated in the pore generated in the domain; and
when it is determined that the CBD is generated outside the pore, removing the CBD generated outside the pore and changing a condition related to generation of the CBD to re-generate the CBD.

6. The method of claim 4, wherein:
the growing the CBD in a stepwise manner further comprises:
determining whether the grown CBD is generated in the pore generated in the domain; and
when it is determined that a volume of the grown CBD is generated outside the pore, removing the volume of the CBD grown outside the pore and changing a growth direction of the CBD to re-grow the CBD.

7. The method of claim 1, wherein:
the calendaring process further comprises:
determining whether a deformation error calculated using a difference in volume of the active material or CBD before and after rolling falls within a preset error range; and
changing an allocation group of a voxel located on a surface of the active material or CBD until the deformation error falls within a preset error range.

8. The method of claim 1, wherein:
the calendaring process further comprises:
determining whether a springback simulation is necessary based on a characteristic of the three-dimensional electrode structure; and
performing the springback simulation using a stress value calculated in the rolling process simulation when it is determined that the springback simulation is necessary.

9. The method of claim 1, wherein:
the calendaring process further comprises:
determining whether a lamination process simulation is necessary based on a characteristic of the three-dimensional electrode structure; and
performing the lamination process simulation by receiving an additional input of a machine parameter necessary for the lamination process and calculating a roll pressure when it is determined that the lamination process simulation is necessary.

10. The method of claim 1, further comprising
an activation process when the three-dimensional electrode structure generated through the coating process and the calendaring process is a negative electrode structure,
wherein the activation process comprises:
by an activation process simulator,
generating a half-cell structure of the three-dimensional electrode structure by using an electrochemical parameter input for the three-dimensional electrode structure;
simulating a battery charging process for the half-cell structure to calculate a lithium ion concentration value in the active material according to a state of lithiation (SOL) of the three-dimensional electrode structure; and
simulating active material expansion by using an amount of change in the lithium ion concentration value in the active material to generate the three-dimensional electrode structure for each SOL.

11. A method for calculating a morphological parameter of a three-dimensional electrode structure generated by the method of any one of claims 1 to 10,
further comprising, by a processor, calculating a morphological parameter for the three-dimensional electrode structure by using a physical property parameter input for the three-dimensional electrode structure.

12. A device for generating a three-dimensional electrode structure, comprising:
a processor configured to receive an input of a design parameter and a mechanical parameter and to generate a three-dimensional electrode structure based on the design parameter and mechanical parameter;
a coating process simulator configured to simulate a coating process by determining sizes of a domain and a voxel based on the design parameter and generating an active material, a conductive additive and binder (CBD), and a current collector in the domain using the design parameter; and
a calendaring process simulator configured to simulate a rolling process for the domain using the mechanical parameter and to simulate a calendaring process by correcting a structural deformation error of the rolled domain.

13. The device of claim 12, wherein:
the coating process simulator is configured
to repeatedly generate the active material until a generation error of the active material generated in the domain falls within a preset error range.

14. The device of claim 13, wherein:
the coating process simulator is configured
to determine whether a volume factor of the active material is within a preset error range, and to change a condition related to generation of the active material when it is determined that the volume factor of the active material is outside the preset error range.

15. The device of claim 12, wherein:
the coating process simulator is configured
to generate the CBD in a pore generated in the domain, to grow the CBD in a stepwise manner so that the CBD generated in the pore does not invade an active material region adjacent to the pore, and
to remove a volume of the grown CBD and change a growth direction of the CBD to re-grow the CBD when a generation error of the grown CBD does not fall within a preset error range.

16. The device of claim 15, wherein:
the coating process simulator is configured
to determine whether the CBD is generated in the pore generated in the domain, and when it is determined that the CBD is generated outside the pore, to remove the CBD generated outside the pore and change a condition related to generation of the CBD to re-generate the CBD.

17. The device of claim 15, wherein:
the coating process simulator is configured
to determine whether the grown CBD is generated in the pore generated in the domain, and when it is determined that a volume of the grown CBD is generated outside the pore, to remove the volume of the CBD grown outside the pore and change a growth direction of the CBD to re-grow the CBD.

18. The device of claim 12, wherein:
the calendaring process simulator is configured
to determine whether a deformation error calculated using a difference in volume of the active material or CBD before and after rolling falls within a preset error range, and to change an allocation group of a voxel located on a surface of the active material or CBD until the deformation error falls within a preset error range.

19. The device of claim 12, wherein:
the calendaring process simulator is configured
to determine whether a springback simulation is necessary based on a characteristic of the three-dimensional electrode structure, and to perform the springback simulation using a stress value calculated in the rolling process simulation when it is determined that the springback simulation is necessary.

20. The device of claim 12, wherein:
the calendaring process simulator is configured
to determine whether a lamination process simulation is necessary based on a characteristic of the three-dimensional electrode structure, and to perform the lamination process simulation by receiving an additional input of a machine parameter necessary for the lamination process and calculating a roll pressure when it is determined that the lamination process simulation is necessary.

21. The device of claim 12, wherein:
the processor is configured to receive an additional input of a mechanochemical parameter,
wherein the device further comprises an activation process simulator, and
wherein the activation process simulator is configured,
when the three-dimensional electrode structure generated through the coating process simulator and the calendaring process simulator is a negative electrode structure, to generate a half-cell structure of the three-dimensional electrode structure by using the electrochemical parameter, to simulate a battery charging process for the half-cell structure to calculate a lithium ion concentration value in the active material according to a state of lithiation (SOL) of the three-dimensional electrode structure, and to simulate active material expansion by using an amount of change in the lithium ion concentration value in the active material to generate the three-dimensional electrode structure for each SOL.

22. A device for calculating a morphological parameter of a three-dimensional electrode structure generated by the device of any one of claims 12 to 21,
wherein the processor is configured
to receive an input of a physical property parameter for the three-dimensional electrode structure and to calculate a morphological parameter for the three-dimensional electrode structure by using the physical property parameter.
